(19) Europäisches Patentamt
European Patent Office
Office européen des brevets

(11) EP 0 621 488 B1

(12) **EUROPEAN PATENT SPECIFICATION**

(45) Date of publication and mention
of the grant of the patent:
**04.02.1998 Bulletin 1998/06**

(51) Int Cl.6: **G01R 27/20**, G01N 27/04,
G01V 3/24, E21B 49/00

(21) Application number: **93830164.5**

(22) Date of filing: **19.04.1993**

(54) **A drill-probe for the measurement of the electric resistivity of a soil**

Bohrsonde zur Messung des elektrischen Bodenwiderstandes

Sonde foreuse pour mesurer la résistivité électrique du sol

(84) Designated Contracting States:
**BE FR IT NL SE**

(43) Date of publication of application:
**26.10.1994 Bulletin 1994/43**

(73) Proprietor: **ENEL S.p.A.**
**I-00198 Roma (IT)**

(72) Inventor: **Morabito, Paolo, c/o Ferraiolo s.r.l.**
**I-20124 Milano (IT)**

(74) Representative: **Ferraiolo, Ruggero et al**
**FERRAIOLO S.r.l.,**
**Via Napo Torriani, 10**
**20124 Milano (IT)**

(56) References cited:
EP-A- 0 294 225       US-A- 3 962 915
US-A- 4 219 776       US-A- 4 236 113

- JOURNAL OF GEOTECHNICAL ENGINEERING
  vol. 111, no. 1 , January 1985 , MADISON,
  WISCONSIN,USA pages 95 - 114 ARULMOLI ET
  AL. 'NEW METHOD FOR EVALUATING
  LIQUEFACTION POTENTIAL'
- IEEE JOURNAL OF OCEANIC ENGINEERING
  vol. 12, no. 1 , January 1987 , NEW YORK US
  pages 301 - 303 WON 'THE GEOMETRICAL
  FACTOR OF A MARINE RESISTIVITY PROBE...'

## Description

The present invention concerns a drill-probe for the measurement of the electric resistivity of a soil, especially that of an incoherent soil that is water saturated, when one wants to find its density for geo-technical purposes, and though this drill-probe may conveniently be used also in non-saturated soil for electric testing.

The field of application of the probe invented is mainly that of studies in the deformability and resistance of foundation soils, two characteristics that depend on the porosity of the soil (that henceforth shall be designated by $\underline{n}$) given by the ratio between the volume of the interstices and the total volume.

In order to render the comprehension of the present invention more immediate current knowledge concerning the relationships existing between electric resistivity and porosity of a soil are summarized below.

Given that, in general, the passage of electricity through a soil takes place through the water in the interstices and that, therefore, the electric resistivity depends on:

- the water content,
- the resistivity of the water itself, a function of the nature and concentration of the substances dissolved in it, and
- the tortuousness of the electrical paths,

if the degree of saturation of a soil is 100%, as is in most sandy soils close to the sea or to a waterway, then all the interstices are full of water and the water content of that soil becomes an index of its porosity, so that it is possible to express a correlation between electric resistivity and porosity. In order that said correlations be free of the dependence on the water's resistivity one refers to the "formation factor" (as per Anglo-Saxon literature on the subject)

$$F = \rho_t / \rho_a$$

$\rho_t$ = soil's electric resistivity including water in the interstices,
$\rho_a$ = electric resistivity of the water in the interstices.

The ratio existing between F and $\underline{n}$ is:

$$F = \underline{n}^{-f}$$

in which f is a coefficient that depends on the nature of the soil.

The tortuousness of the electric paths is functionally linked to the shape and orientation of the solid particles and, therefore, ultimately, to the structure of the soil, so that it becomes possible to define a vertical formation factor

$$F_v = \rho_v / \rho_a = \underline{n}^{-f_v},$$

a horizontal formation factor,

$$F_h = \rho_h / \rho_a = \underline{n}^{-f_h},$$

an average formation factor

$$F_{av} = (F_v + F_h) = \underline{n}^{-f},$$

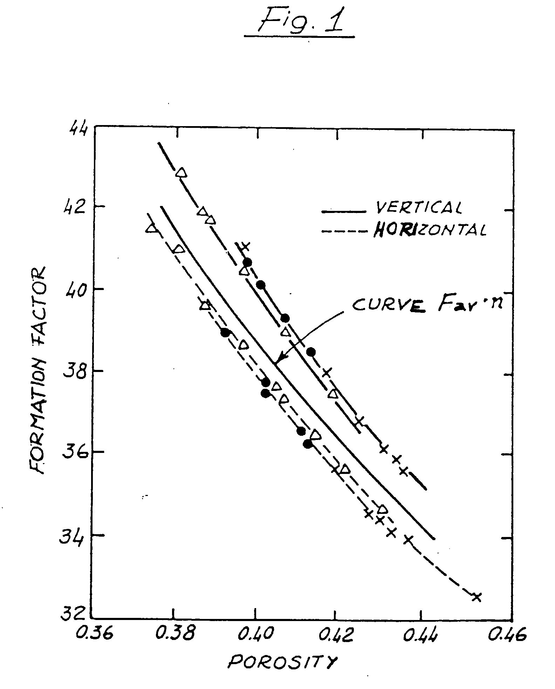

in which $\rho_v$ and $\rho_h$ represent the electric resistivity of the soil vertically and horizontally, respectively, $f_v$ and $f_h$ are constants to be determined in the laboratory that depend on the shape, dimensions and orientation of the particles. The on-site measurement of Fv and Fh therefore allows to determine the porosity of a soil and to evaluate its structural anisotropy through the ratio Fv/Fh taken to be an index of anisotropy. The diagram shown in Fig. 1 is an example of the type of correlation existing between Fh and Fv, on one hand, and the porosity of saturated sand samples reconstituted in the laboratory, on the other.

Apart from the technologies conventionally used on-site for measuring the porosity of a soil, based on the execution of penetrometric tests, the applicant knows of two types of probes designed to measure the resistivity of a soil applying the above mentioned knowledge.

The Dutch paper "Density measurement in situ and critical density" published by "Soil mechanics laboratory" in Delft - 1973, explains that a conical nose drill-probe has been invented, that was already noted for the performance of penetrometric tests, to which a series of electrodes have been applied for the measurement of the vertical electric resistivity, while a second probe was used to measure the water's resistivity. These instruments and techniques require the on-site sampling of improbable undisturbed samples on which to perform a calibration of resistivity values in order to take into account also the disturbance produced in the soil by the penetration of the bit.

In the American "Journal of Geotechnical Engineering" by ASCE - Vol. 111, n° 1 - January 1985, Arulmoli et al. describe a probe that is embodied as a thin wall cylindrical sampler (thickness about 1.6 mm and inside diameter about 73 mm) and that one may presume bears within it three electrodes that together measure the resistivity of the soil within the sampler vertically and horizontally. In fact the vertical measurements are performed according to a given angle compared to the vertical so that operators must perform a translation by means of Mohr's circle in order to calculate the real vertical electric resistivity. Moreover, this probe bears upon its external wall a porous stone through which samples of water are taken from the soil for the measurement of its resistivity. Owing to the fact that the measurement of the resistivity is performed in the volume of soil inside the sampler, also in this case it shall be affected by the disturbance due to the sinking of the sampler in sandy soils; moreover, the fact that said electrodes are not separated into current electrodes for power and voltage electrodes for the measurement can introduce the effect of electrical resistances caused by the contact between the electrodes and the soil into the measurement of the electric resistivity $\rho_t$.

In the following part of this description and in the claims the following simplified terms may be used:

- voltage electrodes - rather than electrodes for the measurement of voltage and - current electrodes - rather than electrodes for the measurement of power current.

The probe invented obviates the inconveniences of the state of the art as described above.

The drill-probe according to the embodiment of the invention comprises a cylindrical body made of an insulating material along the external wall of which two groups of electrodes are supported, in order that, with a four wire layout, a first group measures the vertical electric resistivity and a second group measures the horizontal electric resistivity, said first group consisting of four electrodes, two voltage electrodes and two current electrodes, both voltage electrodes being located between the two current electrodes and each voltage electrode being located close to one of these current electrodes and said second group consisting of at least four electrodes set out along a perimeter of the probe in order to perform the measurement along a single half-plane defined by the line joining the centre of the current electrodes, two electrodes being located in a position that is diametrically opposite in order to function as current electrodes, and the other two being located on the same half-plane, as close as possible to said last electrodes, in order to function as voltage electrodes.

The current electrodes of said first group are all the more distant from one another however more one wishes to increase the range of the measurement while complying with the condition that the flow of current be fully closed from the positive electrode to the negative electrode.

The voltage electrodes of said second group may be four in groups of two on each half-plane and as close as possible to the current electrodes, when, in a non-homogeneous soil, one wishes to determine the horizontal electric resistivity also on the other half-plane.

Moreover, the total number of electrodes in said second group, may be eight, four current electrodes and four voltage electrodes, located in the middle section half way between the two current electrodes in said first group, angularly equidistant, and they can be used also to take part in the measurement of vertical electric resistivity, in order to perform a measurement vertically and four measurements at 90° horizontally and provide an optimum layout pattern and a complete closing of the flow of current through the electrodes.

Because the parameter that is determined by the measurement performed by this probe is an electric resistance obtained by separately measuring current and voltage, the probe must be endowed with well determined constants correlated to the diverse measurement patterns defined by said electrodes in order to reach the electric resistivity.

Apart from the probe's two above-mentioned characteristics, obviously its use must take place complying with the following two conditions: the procedure for sinking into the soil must be by means of self-drilling in order to minimize disturbance in the soil; the measurement of $\rho_v$, $\rho_h$ and $\rho_a$ must be performed at equal temperature because water's electric resistivity is affected by temperature.

The main advantages of this drill-probe are the following:

- the determining of the density is much more reliable compared to the state of the art both because the measurement of electric resistivity is more easily reproduced and because the correlations between the formation factor and porosity do not depend on the voltage status of the soil;
- measurements in the vertical and the horizontal direction allow the highlighting of existing on-site structural anisotropy;
- the self-drilling system for sinking the probe is that which minimizes disturbance in the soil;
- the use of 4 electrodes for the measurement of resistance reduces the error produced by contact electric resistance.

A drill-probe that embodies the invention, constructed in the applicants laboratories, is illustrated as an example with reference to the drawings attached in which:

FIG. 1 is a n/F diagram,
FIG. 2 is a lateral view standing,
FIG. 3 is a first electrode layout for the measurement horizontally,
FIG. 4 is a second electrode layout for the measurement horizontally, and
FIG. 5 is a layout of the electrodes for measurement vertically.

Fig. 1 has been commented previously herein.

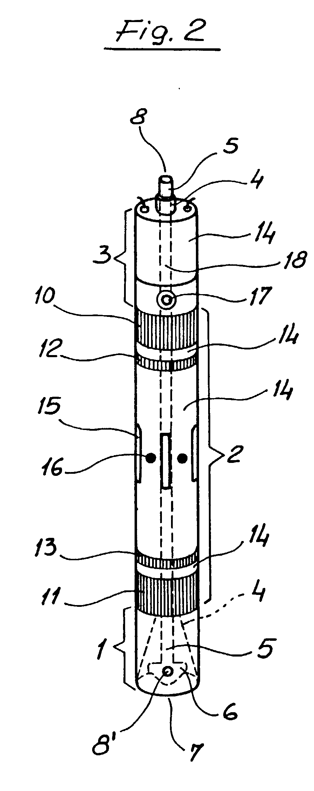

Fig. 2 shows the probe comprising three essential parts:

- a self-drilling device 1, below,
- a central body 2 bearing a system of electrodes for the measurement of soil resistivity in the vertical direction and in the horizontal (or radial) direction,
- a unit 3 for the measurement of the resistivity of water in the interstices, above.

The self-drilling device 1 is simply that adopted for the self-drilling pressure-gauge "Camkometer" (presumably a registered trade-mark) by the company Cambridge in Situ, located in Cambridge - Great Britain. Although it is well known, a few details of this device are provided: within a cylindrical steel support 4, extending within and through the entire length of the probe, runs a tube 5 that conveys a pressurized flow of water to the lower end of the probe; the terminal part of said tube 5 is a spade-shaped bit 6; when the tube 5 is made to rotate, the bit 6 is able to disgregate the soil encountered at the bottom of the probe. The bit 6 is placed inside a protection chamber defined by a cylindrical wall 7 whose external diameter is equal to the external diameter of the drill-probe's central body 2. In the upper opening 8 of the tube 5 a flow of pressurized water is introduced which flows out from two opposite nozzles 8' located on the bit 6 in order to carry the disgregated soil at the drill-head along the annular between the cylindrical support 4 and tube 5, where a pipe that is not shown carries it to the surface.

The central body 2 has an external diameter equal to 100 mm, is 880 mm high, and is made of insulating material 14; said central body bears a system of electrodes comprising: a) adjacent to each end a titanium current electrode (10, 11) of annular shape and 90 mm high; b) between said two current electrodes, two voltage electrodes (12, 13) of annular shape and 10 mm high, each 10 mm distant from the closest current electrode (all the above said electrodes are separated from one another by the insulating material 14 of the probe body); c) in line with the medial section of the probe another 8 electrodes are set out, divided into 4 rectangular elements each 100 mm long and 26 mm wide, shown as 15, and 4 disks with 12 mm diameters shown as 16. These eight electrodes are alternately set out at 45° angles and insulated from one another. Their connections are made so as to realize a four wire measuring configuration for determining electric resistivity both vertically and horizontally.

The unit 3 for the measurement of the resistivity of the water in the interstices located at the top of the probe comprises two porous stones 17 in diametrically opposite positions that take water from the soil and pour it into two cells 18, positioned within the probe (only one stone and one cell are shown). One cell covers an electricity conductivity range from 0 to 10 mS/cm, the other covers a range from 1 to 60 mS/cm. The electronic circuits for the conditioning of signals (not shown in the figure) are also positioned within the probe close to the cells so as to have an exit signal that is directly proportional to the conductivity of the water.

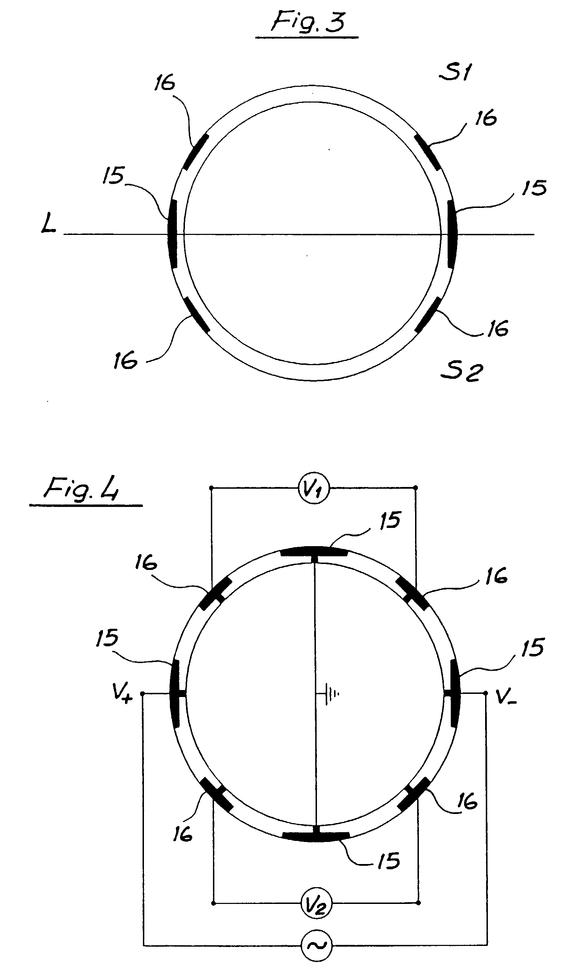

Fig. 3 shows the electrodes in the medial section of said central body 2 in a probe that is suitable for the measurement of electric resistivity horizontally along two half-planes S1, S2 defined by the line L that passes through the centres of the current electrodes 15. As can be seen, in this embodiment the voltage electrodes 16 are four, in groups of two on each of said half-planes, as close as possible to the two current electrodes (15).

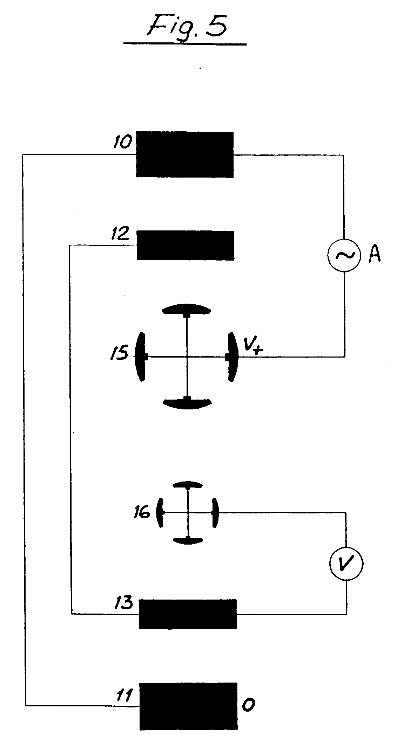

Fig. 4 shows the electrodes in the medial section of said central body 2 in a probe suitable for the measurement of resistivity horizontally along four half-planes. As can be seen in this embodiment the voltage electrodes 16 are again four, while the current electrodes 15 are also four, at 90° angles from one another. In this layout V+ and V- represent the earth balanced voltages applied to two of said electrodes 15, diametrically opposite, used as current electrodes; V1 and V2 are the measurements of voltage performed at the ends of the two pairs of electrodes 16; the other two current electrodes that are not used in this layout are connected to earth. As can be noted from this figure, the layout of the electrodes allows the performance of resistivity measurements on two opposite half-planes having as symmetry axis the joining line of the current electrodes (this explanation should better define the meaning of - half-plane - in the present context). It is possible to rotate the electric configuration as shown by the figure by 90° and perform the measurements along the other two half-planes. These four measurements together provide information concerning the distribution of density along a horizontal plane.

Fig. 5 especially illustrates the layout adopted for measurements made vertically. The electrodes 10 and 11 are both connected to the earth of generator A that supplies the excitation current; the positive of this generator A is connected to said electrodes 15 that represent the positive current electrode. An amperometre (not shown) measures the current flowing from the positive electrode to the earth electrodes through the soil. Voltage electrodes 12 and 13 are in turn connected to one another in order to form a single node; the other node is made up by electrodes 16: the measurement of voltage is performed at the end of these two nodes by voltmetre V.

Follows a brief description of the operations necessary for calibration of the probe.

The measurements of voltage and current, performed with the methods previously described, allow the determining of the electrical resistance R that is linked to the resistivity of the soil by the ratio below:

$$\rho = R\,K$$

where K is a constant that depends on the measurement pattern.

Owing to the fact that the layout for vertical measurements is different from that adopted for horizontal measurements, the values of K differ between the two layouts.

The calibration of the probe consists, in fact, in determining the values for the constant K and is performed by immersing the probe in an undefined means with a known electric resistivity, such as, for example, a tank full of water. From the measurements of the electrical resistance performed in the various configurations and from the measurement of the water's resistivity the values of K are determined. Moreover, the flow lines for the vertical measurement will have a horizontal component that is all the stronger the closer one is to the current electrodes so that the result of the measurement is not a true vertical resistivity, but it will also have a horizontal component. In order to correct this type of error one will apply a numerical model with finite elements by means of which one simulates the behaviour of the probe in an anisotropic means having a ratio between horizontal and vertical electric resistivity the same as that experimentally measured in the laboratory.

## Claims

1. A drill-probe for measuring the electric resistivity of soil that comprises a cylindrical body made of an insulating material (14) and bearing a self-drilling system (1) in order to allow its being sunk into the ground causing the least disturbance to the same and including electrodes that measure the resistivity both vertically and horizontally **characterized** in that it carries upon its outside wall, two groups of measuring electrodes, with a four wire layout, the first of which (10, 11, 12, 13) measures electric resistivity in a vertical direction and the second (15, 16) the electric resistivity in the horizontal direction, said first group consisting of four electrodes two of which (12, 13) for measuring voltage and two (10, 11) for measuring current, both the electrodes for measuring voltage are located between the two electrodes for measuring current and each of them located close to one of the latter and said second group consisting of at least four electrodes (15, 16) positioned along a perimeter of the probe in order to perform the measurement along one half-plane only (S1, S2) defined by the line L joining the centres of the current electrodes, two (15) of the latter electrodes being located in diametrically opposite positions in order to function as current electrodes and the other two (16) being located on the same said half-plane (S1, S2) in order to function as voltage electrodes.

2. A drill-probe according to claim 1 characterized in that the current electrodes (10, 11) of said first group are all the more distant from one another however more one wishes to increase the range of the measurement while complying with the condition that the flow of current be fully closed from the positive electrode to the negative electrode.

3. A drill-probe according to claim 1 characterized in that the electrodes of said first group (10, 11) are in the form of ring-plates.

4. A drill-probe according to claim 1 characterized in that in said second group the two voltage electrodes (16) are located as close as possible to the current electrodes (15).

5. A drill-probe according to claims 1 and 4 characterized in that in said second group the electrodes (16) for measuring voltage are four, adjacent in pairs to a current electrode (15).

6. A drill-probe according to the above claims characterized in that the electrodes in said second group (15, 16) are located in the section half way between the current electrodes (10, 11) and are electrically connected so as to contribute themselves in the measurement of the electric resistivity vertically.

7. A drill-probe according to claims 1, 4, 5 and 6 characterized in that the total number of electrodes in said second group is eight (15, 16) four of which are voltage electrodes (16) and four are current electrodes (15), the voltage electrodes and the current electrodes alternately placed and angularly equidistant and located in the section half way between the voltage electrodes (12, 13) of said first group so as to be used to contribute also to the measurement of electric resistivity vertically.

## Patentansprüche

1. Bohrsonde zum Messen des elektrischen Widerstandes im Erdboden, mit einem zylindrischen Gehäuse aus isolierendem Material (14), das ein Selbstbohrsystem (1) trägt, um es mit geringstmöglicher Störung des Erdbodens in diesen abzusenken, und mit Elektroden, die den Widerstand sowohl vertikal als auch horizontal messen, dadurch **gekennzeichnet**, daß sie an ihrer Außenwand zwei Gruppen von Meßelektroden in einer Vierdraht-Anordnung trägt, von denen die erste (10, 11, 12, 13) den elektrischen Widerstand in einer Vertikalrichtung und die zweite (15, 16) den elektrischen Widerstand in der horizontalen Richtung mißt, wobei die erste Gruppe aus vier Elektroden besteht, und zwar zwei (12, 13) zum Messen der Spannung und zwei (10, 11) zum Messen des Stromes, wobei die beiden Elektroden zur Spannungsmessung zwischen den beiden Elektroden zur Strommessung angeordnet sind und jeweils eine von ihnen nahe einer der letzteren angeordnet sind, und wobei die zweite Gruppe aus mindestens vier Elektroden (15, 16) besteht, die längs eines Umfangs der Sonde angeordnet sind, um die Messung nur längs einer Halbebene (S1, S2) durchzuführen, die definiert ist durch die die Mittelpunkte der Strommeßelektroden verbindende Linie L, wobei zwei (15) der letztgenannten Elektroden einander diametral gegenüber angeordnet sind, um als Stromelektroden zu arbeiten, und die anderen zwei (16) in der gleichen Halbebene (S1, S2) angeordnet sind, um als Spannungselektroden zu arbeiten.

2. Bohrsonde nach Anspruch 1,
dadurch **gekennzeichnet**, daß die Stromelektroden (10, 11) der ersten Gruppe umso mehr voneinander entfernt sind, je mehr der Meßbereich vergrößert werden soll, unter Einhaltung der Bedingung, daß der Stromfluß von der positiven Elektrode zu der negativen Elektrode vollständig geschlossen ist.

3. Bohrprobe nach Anspruch 1,
dadurch **gekennzeichnet**, daß die Elektroden der ersten Gruppe (10, 11) die Form von Ringplatten haben.

4. Bohrsonde nach Anspruch 1,
dadurch **gekennzeichnet**, daß in der zweiten Gruppe die beiden Spannungelektroden (16) so nahe wie möglich bei den Stromelektroden (15) angeordnet sind.

5. Bohrsonde nach Anspruch 1 und 4,
dadurch **gekennzeichnet**, daß in der zweiten Gruppe die Elektroden (16) zur Spannungsmessung vier an der Zahl sind, die jeweils paarweise zu einer Stromelektrode (15) angeordnet sind.

6. Bohrsonde nach den vorstehenden Ansprüchen,
dadurch **gekennzeichnet**, daß die Elektroden der zweiten Gruppe (15, 16) in dem Bereich mittig zwischen den Stromelektroden (10, 11) angeordnet sind und so elektrisch verbunden sind, daß sie selbst zur Messung des elektrischen Widerstandes in Vertikalrichtung beitragen.

7. Bohrsonde nach den Ansprüche 1, 4, 5 und 6,
dadurch **gekennzeichnet**, daß die Gesamtzahl von Elektroden der zweiten Gruppe 8 (15, 16) beträgt, von denen vier Spannungselektroden (16) und vier Stromelektroden (15) sind, wobei die Spannungselektroden und die Stromelektroden miteinander abwechselnd und in gleichen Winkelabständen angeordnet sind und in dem Bereich mittig zwischen den Spannungselektroden (12, 13) der ersten Gruppe liegen, so daß sie verwendet werden können, um auch zu der Messung des elektrischen Widerstandes in Vertikalrichtung beizutragen.

**Revendications**

1. Sonde foreuse pour mesurer la résistivité électrique du sol, comprenant un corps cylindrique réalisé dans un matériau isolant (14) et portant un système de forage automatique (1) pour lui permettre d'être enfoncé dans le sol en produisant le moins de perturbation possible dans ce dernier, et comprenant également des électrodes qui mesurent la résistivité à la fois verticalement et horizontalement, caractérisée en ce qu'
elle porte, sur sa paroi extérieure, deux groupes d'électrodes de mesure dans une disposition à quatre fils, dont le premier groupe (10, 11, 12, 13) mesure la résistivité électrique dans une direction verticale tandis que le second (15, 16) mesure la résistivité électrique dans la direction horizontale, le premier groupe étant constitué de quatre électrodes dont deux (12, 13) sont destinées à mesurer une tension tandis que les deux autres (10, 11) sont destinées à mesurer un courant, les deux électrodes de mesure de tension étant placées entre les deux électrodes de mesure de courant, et chacune d'entre elles étant placée à proximité immédiate de l'une de ces dernières, et le second groupe étant constitué d'au moins quatre électrodes (15, 16) positionnées le long du périmètre de la sonde de manière à effectuer la mesure le long d'un demi-plan seulement (S1, S2) défini par la ligne L joignant les centres des électrodes de courant, deux (15) de ces dernières électrodes étant placées dans des positions diamétralement opposées de manière à fonctionner en électrodes de courant, tandis que les deux autres (16) sont placées sur le même demi-plan (S1, S2) de manière à fonctionner en électrodes de tension.

2. Sonde foreuse selon la revendication 1,
caractérisée en ce que
les électrodes de courant (10, 11) du premier groupe sont toutes les plus distantes possibles les unes des autres, bien que plus d'un souhaite augmenter la plage de mesure tout en satisfaisant à la condition que le débit de courant soit complètement fermé de l'électrode positive à l'électrode négative.

3. Sonde foreuse selon la revendication 1,
caractérisée en ce que
les électrodes du premier groupe (10, 11) se présentent sous la forme de plaques annulaires.

4. Sonde foreuse selon la revendication 1,
caractérisée en ce que
dans le second groupe, les deux électrodes de tension (16) sont placées aussi près que possible des électrodes de courant (15).

5. Sonde foreuse selon les revendications 1 et 4,
caractérisée en ce que
dans le second groupe, les électrodes (16) de mesure de tension sont au nombre de quatre et sont adjacentes, par paires, à une électrode de courant (15).

**6.** Sonde foreuse selon l'une quelconque des revendications précédentes,
caractérisée en ce que
les électrodes, dans le second groupe (15, 16), sont placées dans la section à mi-chemin entre les électrodes de courant (10, 11), et sont connectées électriquement de manière à contribuer verticalement d'elles-mêmes à la mesure de la résistivité électrique.

**7.** Sonde foreuse selon les revendications 1, 4, 5 et 6, caractérisée en ce que
le nombre total d'électrodes dans le second groupe est de huit (15, 16) dont quatre sont des électrodes de tension (16) et quatre sont des électrodes de courant (15), les électrodes de tension et les électrodes de courant étant placées alternativement dans des positions angulairement équidistantes, en étant situées dans la section à mi-chemin entre les électrodes de tension (12, 13) du premier groupe, de manière à être utilisées pour contribuer verticalement également à la mesure de la résistivité électrique.

## Fig. 1

## Fig. 2

## Fig. 3

## Fig. 4

## Fig. 5